# EUROPEAN PATENT APPLICATION

(11) **EP 4 198 533 A1**
(43) Date of publication of application: **21.06.2023**
(21) Application number: 21855783.3
(22) Date of filing: 26.02.2021
(51) Int. Cl.: G01R 31/367, G01R 31/392

(54) **INFORMATION PROCESSING DEVICE, INFORMATION PROCESSING METHOD, AND PROGRAM**

(30) Priority: 13.08.2020 WO PCT/JP2020/030800
(71) Applicant: Terawatt Technology K.K., Yokohama-shi, Kanagawa 226-0026 (JP)
(72) Inventor: ARAI, Juichi, Yokohama-shi, Kanagawa 226-0026 (JP); OGATA, Ken, Yokohama-shi, Kanagawa 226-0026 (JP); SATO, Yoshikuni, Yokohama-shi, Kanagawa 226-0026 (JP); IMOTO, Hiroshi, Yokohama-shi, Kanagawa 226-0026 (JP)
(74) Representative: Mewburn Ellis LLP
(86) International application number: PCT/JP2021/007491
(87) International publication number: WO 2022/034704

(57) **Abstract**

The purpose of the invention is to provide an information processing device including a first reception unit which receives from a plurality of secondary battery management systems, charge/discharge data of secondary batteries managed by the secondary battery management systems, and an estimation model generation unit which generates an estimation model for estimating a degradation indicator indicating a state of degradation of the secondary battery based on the charge/discharge data.

## Description

### Background

### Field

The present invention relates to an information processing device, an information processing method, and a program.

### Description of Related Art

In recent years, a technology for converting natural energy such as sunlight or wind power into electrical energy has been attracting attention. Along with this, various secondary batteries have been developed as storage devices which are high in safety and capable of storing a large amount of electrical energy. In particular, a secondary battery using a negative electrode having no negative electrode active material such as a carbon material or a lithium metal has been developed for the purpose of achieving higher energy density and improving productivity as compared with a lithium ion secondary battery or the like. There has been disclosed in, for example, Japanese Unexamined Patent Application Publication No. 2019-25971, a secondary battery in which metal particles are formed on a negative electrode current collector and are moved from a positive electrode by charging to form a lithium metal on the negative electrode current collector.

Since such a secondary battery is degraded as it is repeatedly charged and discharged during use, various estimation methods for the degradation state of the secondary battery have been proposed. In this regard, the present inventors have found that, for the secondary battery which does not have the negative electrode active material described above, the degradation state shows various parameters of the secondary battery and good linearity.

### Summary

However, for example, in estimating a degradation state of a secondary battery, it may be difficult to perform the estimation highly accurately even if the estimation is performed based only on data obtained from the secondary battery. On the other hand, in BaaS (Battery as a Service) which comprehensively provides various services related to the use of secondary batteries to plural users, there is an aspect that data of the secondary batteries used by each user is not fully utilized.

The present invention has been made in view of such circumstances, and an object thereof is to provide an information processing device, an information processing method, and a program capable of effectively utilizing data on a plurality of secondary batteries and predicting a degradation state of the secondary batteries with high accuracy.

An information processing device according to an aspect of the present invention includes a first reception unit which receives from a plurality of secondary battery management systems, charge/discharge data of secondary batteries managed by the secondary battery management systems, and an estimation model generation unit which generates an estimation model for estimating a degradation indicator indicating a state of degradation of each secondary battery based on the charge/discharge data.

According to this aspect, after receiving from a plurality of secondary battery management systems, charge/discharge data of secondary batteries managed by the secondary battery management systems, it is possible to generate an estimation model for estimating a degradation indicator of the secondary battery based on these charge/discharge data. Therefore, it is possible to effectively utilize data related to a plurality of secondary batteries and predict a degradation state of the secondary batteries with high accuracy.

According to the present invention, it is possible to provide an information processing device, an information processing method, and a program capable of effectively utilizing data related to a plurality of secondary batteries and predicting a degradation state of the secondary batteries with high accuracy.

### Brief Description of Drawings

Fig. 1 is a block diagram showing an example of a schematic configuration of a management system 1 according to the present embodiment;
Fig. 2 is a block diagram showing an example of a schematic configuration of a power supply device 10 according to the present embodiment;
Fig. 3 is a schematic cross-sectional view of a lithium secondary battery 101 according to the present embodiment;
Fig. 4 is a block diagram showing an example of a functional configuration of a BMS 400 according to the present embodiment;
Fig. 5 is a block diagram showing an example of a functional configuration of a server device 20 according to the present embodiment;
Fig. 6 is a diagram showing an example of a data structure of charge/discharge data according to the present embodiment;
Fig. 7 is a diagram showing characteristic information of "OCV after discharge" and "SOH" of the lithium secondary battery 101 according to various examples;
Fig. 8 is a diagram showing characteristic information of "OCV after charge-OCV after discharge" and "charge/discharge capacity" of the lithium secondary battery 101 according to various examples;
Fig. 9 is a diagram showing an example of an operation sequence of a generation process of an estimation model by the management system 1 according to the present embodiment;
Fig. 10 is a diagram showing an example of an operation sequence of an estimation process of a degradation indicator by the management system 1 according to the present embodiment; and
Fig. 11 is a diagram showing an example of a screen 1000 of notification information according to the present embodiment.

### Detailed Description

Preferred embodiments of the present invention will be described with reference to the accompanying drawings. Incidentally, in each figure, those designated at the same reference numerals have the same or similar configurations.
(1) Management System 1

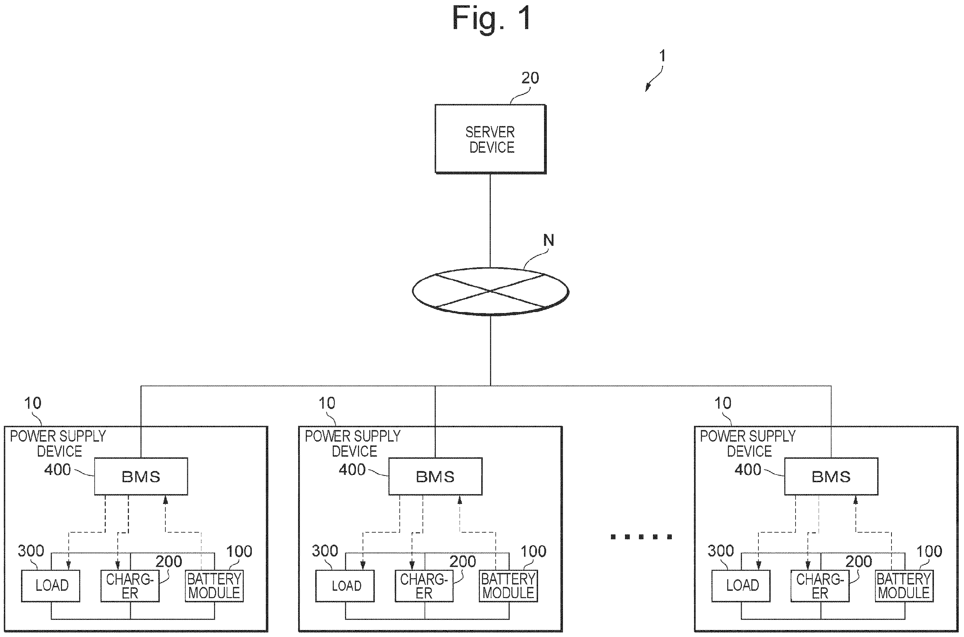

Fig. 1 is a block diagram showing an example of a schematic configuration of a management system 1 according to the present embodiment. As shown in Fig. 1, the management system 1 includes, for example, a plurality of power supply devices 10 and a server device 20. Each of the power supply devices 10 is a power supply device used by a user and includes, for example, a battery module 100, a charger 200, a load 300, and a battery management system (BMS) 400. Each BMS 400 and the server device 20 are connected to a communication network N such as the Internet so that information can be transmitted and received to each other, for example. In the management system 1, for example, the server device 20 provides BaaS (Battery as a Service) which comprehensively provides various services related to the use of a secondary battery to each user who uses the power supply device 10.

### (2) Power Supply Device 10

### (2-1) Overall Configuration

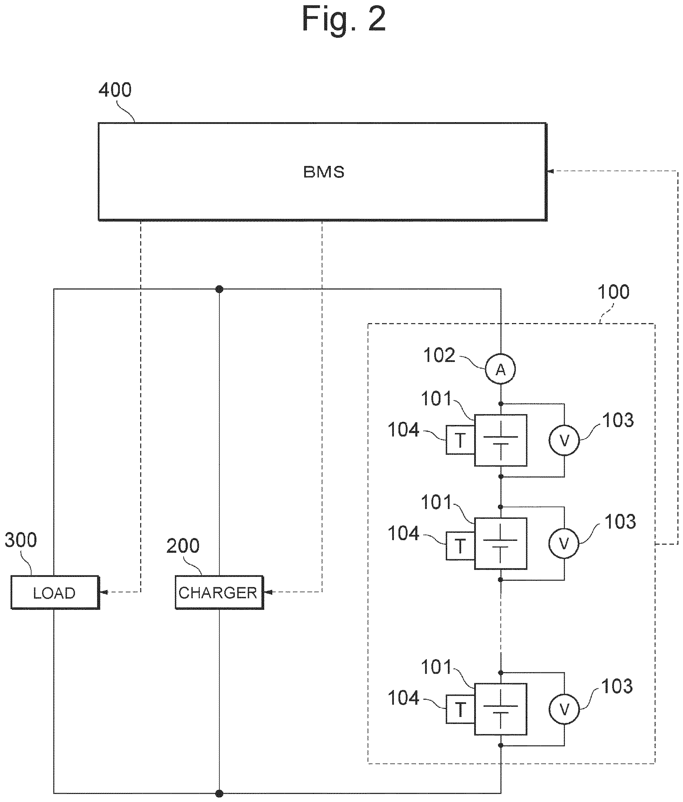

Fig. 2 is a block diagram showing an example of a schematic configuration of the power supply device 10 according to the present embodiment.

The power supply device 10 includes, for example, a battery module 100, a charger 200, a load 300, and a BMS 400.

The battery module 100 includes a lithium secondary battery 101 as a single cell, or a plurality of lithium secondary batteries 101 connected in series and/or in parallel. The number of the lithium secondary batteries 101 included in the battery module 100 is not limited in particular. The lithium secondary batteries 101 may respectively have the same characteristics or may respectively have different characteristics. The details of the configuration of the lithium secondary battery 101 will be described later.

The battery module 100 further has a current sensor 102 connected in series to the lithium secondary batteries 101. The current sensor 102 is connected in series to the lithium secondary batteries 101. The current sensor 102 measures a current flowing through these lithium secondary batteries 101 and supplies its current value to the BMS 400.

The battery module 100 further has a voltage sensor 103 and a temperature sensor 104 provided in each of the lithium secondary batteries 101. Each voltage sensor 103 is connected in parallel to the lithium secondary battery 101. The voltage sensor 103 measures the voltage (inter-terminal voltage) between a positive electrode terminal and a negative electrode terminal of the lithium secondary battery 101 and supplies its voltage value to the BMS 400. Further, the temperature sensor 104 is thermally coupled to each of the lithium secondary batteries 101, and measures the temperature of the lithium secondary battery 101 and supplies its temperature value to the BMS 400.

The configuration of the charger 200 is not limited in particular, but the charger 200 may be configured to be provided with, for example, a charging connector to which a charging plug connected to an external power supply can be connected, and to convert power supplied from the external power supply into charging power of the lithium secondary battery 101. The lithium secondary battery 101 is connected to the charger 200, for example, and can be charged by a charging current supplied by the charger 200 under the control of the BMS 400.

The configuration of the load 300 is not limited in particular, but it may be configured as, for example, a drive device of an electric vehicle (electric car, hybrid car), or the like. The lithium secondary battery 101 is connected to the load 300, for example, and can supply a current to the load 300 under the control of the BMS 400.

The BMS 400 controls the charging and discharging of the lithium secondary battery 101 included in the battery module 100. The configuration of the BMS 400 will be described later.

### (2-2) Lithium Secondary Battery 101

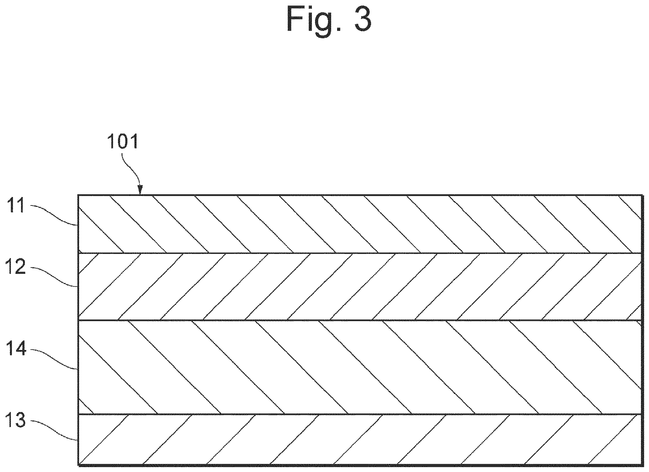

Fig. 3 is a schematic cross-sectional view of the lithium secondary battery 101 according to the present embodiment. The lithium secondary battery 101 of the present embodiment includes a positive electrode 12 and a negative electrode 13 having no negative electrode active material. Further, in the lithium secondary battery 101, a positive electrode current collector 11 is arranged on the side opposite to the surface of the positive electrode 12 facing the negative electrode 13, and a separator 14 is arranged between the positive electrode 12 and the negative electrode 13. Hereinafter, each configuration of the lithium secondary battery 101 will be described.

### (Negative Electrode)

The negative electrode 13 has no negative electrode active material. In the present specification, the "negative electrode active material" is a substance which causes an electrode reaction, that is, an oxidation reaction and a reduction reaction at the negative electrode. Specifically, the negative electrode active material of the present embodiment may include a lithium metal and a host substance of a lithium element (lithium ion or lithium metal). The host substance of the lithium element means a substance provided for holding lithium ions or the lithium metal in the negative electrode 13. A mechanism for such holding is not limited in particular, but may include, for example, intercalation, alloying, and occlusion of metal clusters, and the like, typically, intercalation.

In the lithium secondary battery 101 of the present embodiment, since the negative electrode 13 does not have the negative electrode active material before the initial charging of the battery, the lithium metal is precipitated on the negative electrode 13, and the precipitated lithium metal is electrolytically eluted so that charging and discharging are performed. Therefore, in the lithium secondary battery 101 of the present embodiment, the volume occupied by the negative electrode active material and the mass of the negative electrode active material are reduced as compared with the lithium secondary battery 101 having the negative electrode active material, and the volume and mass of the entire battery are reduced, so that the energy density is high in principle.

In the lithium secondary battery 101 of the present embodiment, the negative electrode 13 does not have the negative electrode active material before the initial charging of the battery, the lithium metal is precipitated on the negative electrode by charging of the battery, and the precipitated lithium metal is electrolytically eluted by discharging of the battery. Therefore, in the lithium secondary battery 101 of the present embodiment, the negative electrode 13 does not substantially have the negative electrode active material even at the end of discharging of the battery. Therefore, in the lithium secondary battery 101 of the present embodiment, the negative electrode 13 acts as a negative electrode current collector.

Comparing the lithium secondary battery 101 of the present embodiment with a lithium ion battery (LIB) and a lithium metal battery (LMB), they are different in the following points.

In the lithium ion battery (LIB), the negative electrode has a host substance of a lithium element (lithium ion or lithium metal), the substance is filled with the lithium element by charging of the battery, and the host substance releases the lithium element so that the battery is discharged. The LIB differs from the lithium secondary battery 101 of the present embodiment in that the negative electrode has the host substance of the lithium element.

The lithium metal battery (LMB) is manufactured by using an electrode having a lithium metal on its surface or a lithium metal alone as a negative electrode. That is, the LMB differs from the lithium secondary battery 101 of the present embodiment in that the negative electrode has a lithium metal which is a negative electrode active material immediately after assembling the battery, that is, before the initial charging of the battery. The LMB uses an electrode containing a lithium metal high in flammability and reactivity for its production, but the lithium secondary battery 101 of the present embodiment is more superior in safety and productivity because it uses the negative electrode 13 having no lithium metal.

In the present specification, the term "the negative electrode has no negative electrode active material" means that the negative electrode does not have or substantially does not have the negative electrode active material. The fact that the negative electrode has substantially no negative electrode active material means that the content of the negative electrode active material in the negative electrode is 10% by mass or less with respect to the entire negative electrode. The content of the negative electrode active material in the negative electrode is preferably 2% by mass or less with respect to the entire negative electrode, and may be 1.0% by mass or less, 0.1% by mass or less, or 0.0% by mass or less. When the negative electrode does not have the negative electrode active material or the content of the negative electrode active material in the negative electrode is within the above range, the energy density of the lithium secondary battery 101 becomes high.

In the present specification, the term "the lithium metal is precipitated on the negative electrode" means that the lithium metal is precipitated on the surface of the negative electrode or at least one place on the surface of a solid electrolyte interface (SEI) layer to be described later formed on the surface of the negative electrode. For example, in Fig. 1, the lithium metal is precipitated on the surface of the negative electrode 13 (the interface between the negative electrode 13 and the separator 14).

In the present specification, the term "before the battery is initially charged" means a state from the time when the battery is assembled to the time when the battery is charged for the first time. Further, the term "at the end of discharging" of the battery means a state in which the voltage of the battery is 1.0 V or more and 3.8 V or less, preferably 1.0 V or more and 3.0 V or less.

In the present specification, the term, "the lithium secondary battery 101 having the negative electrode having no negative electrode active material" means that the negative electrode does not have the negative electrode active material before the initial charging of the battery or at the end of its discharging. Therefore, the phrase "the negative electrode having no negative electrode active material" may be paraphrased with "a negative electrode having no negative electrode active material before the initial charging of the battery or at the end of its discharging", "a negative electrode having no negative electrode active material other than the lithium metal regardless of the state of charging of the battery and having no lithium metal before the initial charging or at the end of discharging", or "a negative electrode current collector having no lithium metal before the initial charging or at the end of discharging", or the like. Further, the term "the lithium secondary battery 101 including the negative electrode having no negative electrode active material" may be paraphrased with an anode-free lithium battery, a zero anode lithium battery, or an anodeless lithium battery.

In the negative electrode 13 of the present embodiment, the content of the negative electrode active material other than the lithium metal is 10% by mass or less with respect to the entire negative electrode regardless the state of charging of the battery, preferably 2% by mass or less, and may be 1.0% by mass or less, 0.1 % by mass or less, or 0.0% by mass or less. Further, in the negative electrode 13 of the present embodiment, before the initial charging or at the end of discharging, the content of the lithium metal is 10% by mass or less with respect to the entire negative electrode, preferably 2% by mass or less, and may be 1.0% by mass or less, 0.1% by mass or less, or 0.0% by mass or less. The negative electrode 13 preferably has a lithium metal content of 10% by mass or less with respect to the entire negative electrode 13 before initial charging and at the end of discharging (even among this range, preferably, the content of the lithium metal is 2% by mass or less with respect to the entire negative electrode 13, and may be 1.0% by mass or less, 0.1% by mass or less, or 0.0% by mass or less.).

In the lithium secondary battery 101 of the present embodiment, when the voltage of the battery is 1.0 V or more and 3.5 V or less, the content of the lithium metal may be 10% by mass or less with respect to the entire negative electrode 13 (preferably 2% by mass or less, and may be 1.0% by mass or less, 0.1 % by mass or less, or 0.0% by mass or less); when the voltage of the battery is 1.0 V or more and 3.0 V or less, the content of the lithium metal may be 10% by mass or less with respect to the entire negative electrode 13 (preferably 2% by mass or less, and may be 1.0% by mass or less, 0.1% by mass or less, or 0.0% by mass or less); or when the voltage of the battery is 1.0 V or more and 2.5 V or less, the content of the lithium metal may be 10% by mass or less with respect to the entire negative electrode (preferably 2% by mass or less, and may be 1.0% by mass or less, 0.1% by mass or less, or 0.0% by mass or less).

Further, in the lithium secondary battery 101 of the present embodiment, a ratio M_{3.0}/M_{4.2} of a mass M_{3.0} of the lithium metal precipitated on the negative electrode 13 in the state in which the voltage of the battery is 3.0 V, to a mass M_{4.2} of the lithium metal precipitated on the negative electrode 13 in the state in which the voltage of the battery is 4.2 V, is preferably 20% or less, more preferably 15% or less, still more preferably 10% or less. The ratio M_{3.0}/M_{4.2} may be 8.0% or less, 2% or less, 3.0% or less, or 1.0% or less.

As examples of the negative electrode active material of the present embodiment, there may be mentioned a lithium metal and an alloy containing the lithium metal, a carbon-based substance, a metal oxide, a metal alloyed with lithium, and an alloy containing the metal, etc. The carbon-based substance is not limited in particular, but may include, for example, graphene, graphite, hard carbon, mesoporous carbon, carbon nanotubes, and carbon nanohorns, etc. The metal oxide is not limited in particular, but may include, for example, a titanium oxide-based compound, a tin oxide-based compound, and a cobalt oxide-based compound, etc. The metal alloyed with the lithium may include, for example, silicon, germanium, tin, lead, aluminum, and gallium.

The negative electrode 13 in the present embodiment is not particularly limited as long as it does not have a negative electrode active material and can be used as a current collector, but may include at least one type selected from a group consisting of, for example, Cu, Ni, Ti, and Fe, other metals which do not react with Li, an alloy of these, and stainless steel (SUS). Incidentally, when SUS is used for the negative electrode 13, various conventionally known types can be used as the type of SUS. As the negative electrode material as described above, one type is used alone or two or more types are used in combination. Incidentally, in the present specification, the term "the metal which does not react with Li" means a metal which does not react with the lithium ions or lithium metal to form an alloy under the operating conditions of the lithium secondary battery 101.

The negative electrode 13 of the present embodiment preferably consists of at least one type selected from a group consisting of Cu, Ni, Ti, and Fe, an alloy of these, and stainless steel (SUS). More preferably, it consists of at least one type selected from a group consisting of Cu and Ni, an alloy of these, and stainless steel (SUS). Further preferably, the negative electrode 13 is Cu and Ni, an alloy of these, or the stainless steel (SUS). When such a negative electrode 13 is used, the energy density and productivity of the battery tend to be even more excellent.

The average thickness of the negative electrode 13 is preferably 4 µm or more and 20 µm or less, more preferably 5 µm or more and 18 µm or less, and further preferably 6 µm or more and 15 µm or less. According to such an aspect, the volume occupied by the negative electrode 13 in the battery is reduced, so that the energy density of the battery is further improved.

### (Positive Electrode)

As long as the positive electrode 12 has a positive electrode active material, the positive electrode 12 is not particularly limited as long as it is generally used for the lithium secondary battery 101, but the known material can be appropriately selected depending on the use of the lithium secondary battery 101. The positive electrode 12 is high in stability and output voltage because it has the positive electrode active material.

In the present specification, the term "the positive electrode active material" means a substance which causes an electrode reaction, that is, an oxidation reaction and a reduction reaction at the positive electrode. Specifically, the positive electrode active material of the present embodiment may include a host material of a lithium element (typically, lithium ion).

Such a positive electrode active material is not limited in particular, but may include, for example, a metal oxide and a metal phosphate. The metal oxide is not limited in particular, but may include, for example, a cobalt oxide-based compound, a manganese oxide-based compound, and a nickel oxide-based compound, etc. The metal phosphate is not limited in particular, but may include, for example, an iron phosphate-based compound and a cobalt phosphate-based compound. A typical positive electrode active material may include LiCoO₂, LiNi ₓCo _{y}Mn _{z}O (x + y + z = 1), LiNi ₓMn _{y}O (x + y = 1), LiNiO ₂, LiMn ₂O ₄, LiFePO, LiCoPO, LiFeOF, LiNiOF, and TiS₂. As the positive electrode active material as described above, one type is used alone or two or more types are used in combination.

The positive electrode 12 may contain components other than the above-mentioned positive electrode active material. Such components are not limited in particular, but may include, for example, a known conductive assistant, a binder, a polymer electrolyte, and an inorganic solid electrolyte.

The conductive assistant in the positive electrode 12 is not limited in particular, but may include, for example, a carbon black, a single-wall carbon nanotube (SWCNT), a multi-wall carbon nanotube (MWCNT), a carbon nanofiber (CF), and an acetylene black, etc. Further, the binder is not limited in particular, but may include, for example, polyvinylidene fluoride, polytetrafluoroethylene, styrene-butadiene rubber, an acrylic resin, and a polyimide resin, etc.

The content of the positive electrode active material in the positive electrode 12 may be, for example, 2% by mass or more and 100% by mass or less with respect to the entire positive electrode 12. The content of the conductive assistant may be, for example, 0.5% by mass and 30% by mass or less with respect to the entire positive electrode 12. The content of the binder may be, for example, 0.5% by mass and 30% by mass or less with respect to the entire positive electrode 12. The total content of the solid polyelectrolyte and the inorganic solid electrolyte may be, for example, 0.5% by mass and 30% by mass or less with respect to the entire positive electrode 12.

### (Positive Electrode Current Collector)

The positive electrode current collector 11 is arranged on one side of the positive electrode 12. The positive electrode current collector 11 is not particularly limited as long as it is a conductor which does not react with lithium ions in the battery. As such a positive electrode current collector 11, there is mentioned, for example, aluminum.

The average thickness of the positive electrode current collector 11 is preferably 4 µm or more and 20 µm or less, more preferably 5 µm or more and 18 µm or less, and further preferably 6 µm or more and 15 µm or less. According to such an aspect, the volume occupied by the positive electrode current collector 11 in the lithium secondary battery 101 is reduced, so that the energy density of the lithium secondary battery 101 is further improved.

### (Separator)

The separator 14 is a member for ensuring the ionic conductivity of lithium ions which become charge carriers between the positive electrode 12 and the negative electrode 13, while preventing the battery from short-circuiting by separating the positive electrode 12 and the negative electrode 13 from each other. The separator 14 is made of a material which does not have electron conductivity and does not react with the lithium ions. Further, the separator 14 also assumes a role of holding an electrolytic solution. Although the material itself constituting the separator 14 does not have ionic conductivity, the separator 14 holds the electrolytic solution, so that the lithium ions are conducted through the electrolytic solution. The separator 14 is not limited as long as it plays the above role, but is composed of, for example, a porous polyethylene (PE) film, a polypropylene (PP) film, or a laminated structure thereof.

The separator 14 may be covered with a separator coating layer. The separator coating layer may cover both sides of the separator 14 or may cover only one side thereof. The separator coating layer is not particularly limited as long as it is a member which does not react with the lithium ions, but it is preferable that the separator 14 and the layer adjacent to the separator 14 can be firmly adhered to each other. Such a separator coating layer is not limited in particular, but may include those containing binders like, for example, polyvinylidene fluoride (PVDF), a mixture of styrene-butadiene rubber and carboxymethyl cellulose (SBR-CMC), polyacrylic acid (PAA), lithium polyacrylic acid (Li-PAA), polyimide (PI), polyamideimide (PAI), and aramid. In the separator coating layer, inorganic particles such as silica, alumina, titania, zirconia, magnesium oxide, magnesium hydroxide, and lithium nitrate, etc. may be added to the binder. Incidentally, the separator 14 may not have the separator coating layer or may have the separator coating layer.

The average thickness of the separator 14 is preferably 30 µm or less, more preferably 25 µm or less, and further preferably 20 µm or less. According to such an aspect, since the volume occupied by the separator 14 in the lithium secondary battery 101 is reduced, the energy density of the lithium secondary battery 101 is further improved. Further, the average thickness of the separator 14 is preferably 5 µm or more, more preferably 7 µm or more, and further preferably 10 µm or more. According to such an aspect, the positive electrode 12 and the negative electrode 13 can be more reliably isolated from each other, and the short-circuiting of the battery can be further suppressed.

### (Electrolytic Solution)

The lithium secondary battery 101 preferably has an electrolytic solution. In the lithium secondary battery 101, the electrolytic solution may be infiltrated into the separator 14, or may be enclosed in a closed container together with a laminate of the positive electrode current collector 11, the positive electrode 12, the separator 14, and the negative electrode 13. The electrolytic solution is a solution containing an electrolyte and a solvent and having ionic conductivity and acts as a conductive path for the lithium ions. Therefore, according to the aspect including the electrolytic solution, the internal resistance of the battery is further reduced, and the energy density, capacity, and cycle characteristics thereof are further improved.

The electrolytic solution preferably contains a fluoroalkyl compound having at least one of a monovalent group represented by the following formula (A) and a monovalent group represented by the following formula (B) as a solvent.

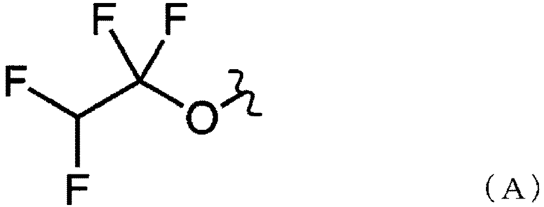

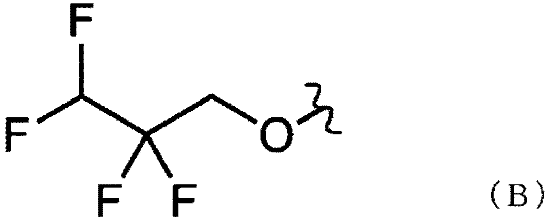

However, in the formula, a wavy line represents a binding site in the monovalent group.

Generally, in an anode-free lithium secondary battery 101 having an electrolytic solution, a solid electrolyte interface layer (SEI layer) is formed on the surface of the negative electrode or the like by decomposing the solvent or the like in the electrolytic solution. The SEI layer suppresses further decomposition of the components in the electrolytic solution in the lithium secondary battery 101, irreversible reduction of lithium ions due to the decomposition, and the generation of gas, etc. Further, since the SEI layer has ionic conductivity, the reactivity of the lithium metal precipitation reaction becomes uniform in the surface direction of the negative electrode surface on the negative electrode surface on which the SEI layer is formed. When the above-mentioned fluoroalkyl compound is used as the solvent in the lithium secondary battery 101, the SEI layer is likely to be formed on the surface of the negative electrode, and the growth of a dendrite-like lithium metal on the negative electrode is further suppressed, thus resulting in the cycle characteristics tending to be further improved.

Incidentally, in the present specification, the term "the compound is "contained as the solvent" means that the compound alone or a mixture with another compound may be liquid in the usage environment of the lithium secondary battery 101, and further, an electrolyte may be dissolved to enable an electrolytic solution in a solution phase to be produced.

Such a fluoroalkyl compound may include a compound having an ether bond (hereinafter referred to as an "ether compound"), a compound having an ester bond, and a compound having a carbonate bond, etc. The fluoroalkyl compound is preferably an ether compound from the viewpoint of further improving the solubility of the electrolyte in the electrolytic solution and the viewpoint of further facilitating the formation of the SEI layer.

The ether compound which is of the fluoroalkyl compound may include, an ether compound having both the monovalent group represented by the formula (A) and the monovalent group represented by the formula (B) (also called, a "first fluorine solvent"), an ether compound having the monovalent group represented by the formula (A) and having no monovalent group represented by the formula (B) (also called a "second fluorine solvent"), and an ether compound having no monovalent group represented by the formula (A) and having the monovalent group represented by the formula (B) (also called, a "third fluorine solvent"), and the like.

The first fluorine solvent may include 1,1,2,2-tetrafluoroethyl-2,2,3,3-tetrafluoropropyl ether, 1,1,2,2-tetrafluoroethyl-2,2,3,3-tetrafluoropropyldiethoxymethane, and 1,1,2,2-tetrafluoroethyl-2,2,3,3-tetrafluoropropyldiethoxypropane, and the like. From the viewpoint of effectively and surely exerting the effect of the above-mentioned fluoroalkyl compound, 1,1,2,2-tetrafluoroethyl-2,2,3,3-tetrafluoropropyl ether is preferable as the first fluorine solvent.

The second fluorine solvent may include, for example, 1,1,2,2-tetrafluoroethyl-2,2,2-trifluoroethyl ether, methyl-1,1,2,2-tetrafluoroethyl ether, ethyl-1,1,2,2-tetrafluoroethyl ether, propyl-1,1,2,2-tetrafluoroethyl ether, 1H, 1H, 5H-perfluoropentyl-1,1,2,2-tetrafluoroethyl ether, and 1H, 1H, 5H-octafluoropentyl-1,1,2,2-tetrafluoroethyl ether, and the like. From the viewpoint of effectively and surely exerting the effect of the above-mentioned fluoroalkyl compound, 1,1,2,2-tetrafluoroethyl-2,2,2-trifluoroethyl ether, methyl-1, 1,2,2-tetrafluoroethyl ether, ethyl-1,1,2,2-tetrafluoroethyl ether, and 1H, 1H, 5H-octafluoropentyl-1,1,2,2-tetrafluoroethyl ether are preferable as the second fluorine solvent.

The third fluorine solvent may include, for example, difluoromethyl-2,2,3,3-tetrafluoropropyl ether, trifluoromethyl-2,2,3,3-tetrafluoropropyl ether, fluoromethyl-2,2,3,3-tetrafluoropropyl ether, and methyl-2,2,3,3-tetrafluoropropyl ether, and the like. From the viewpoint of effectively and surely exerting the effect of the above-mentioned fluoroalkyl compound, difluoromethyl-2,2,3,3-tetrafluoropropyl ether is preferable as the third fluorine solvent.

The electrolytic solution may contain a solvent having neither the monovalent group represented by the formula (A) nor the monovalent group represented by the formula (B). Such a solvent is not particularly limited, but may include, for example, solvents containing no fluorine such as dimethyl ether, triethylene glycol dimethyl ether, dimethoxyethane, diethylene glycol dimethyl ether, acetonitrile, dimethyl carbonate, diethyl carbonate, ethyl methyl carbonate, ethylene carbonate, propylene carbonate, chloroethylene carbonate, methyl acetate, ethyl acetate, propyl acetate, methylpropionate, ethyl propionate, trimethyl phosphate, and triethyl phosphate, etc. , and solvents containing the fluorine such as methyl nonafluorobutyl ether, ethyl nonafluorobutyl ether, 1,1, 1,2,2,3,4,5,5,5-decafluoro-3-methoxy-4-trifluoromethylpentane, methyl-2,2,3,3,3-pentafluoropropyl ether, 1,1,2,3,3,3-hexafluoropropylmethyl ether, ethyl-1,1,2,3,3,3-hexafluoropropyl ether, and tetrafluoroethyl tetrafluoropropyl ether, etc.

In the above-mentioned solvents including the above-mentioned fluoroalkyl compound, one type can be used alone, or two or more types can be used in combination.

The content of the fluoroalkyl compound in the electrolytic solution is not limited in particular, but is preferably 40% by volume or more, more preferably 2% by volume or more, still more preferably 60% by volume or more, or even more preferably 70% by volume or more with respect to the total amount of the solvent components of the electrolytic solution. When the content of the fluoroalkyl compound is within the above range, the SEI layer is more likely to be formed, so that the cycle characteristics of the battery tend to be further improved. The upper limit of the content of the fluoroalkyl compound is not limited in particular, and the content of the fluoroalkyl compound may be 100% by volume or less, 95% by volume or less, 90% by volume or less, or 80% by volume or less, with respect to the total amount of the solvent components of the electrolytic solution.

The electrolyte contained in the electrolytic solution is not particularly limited as long as it is a salt, but may include, for example, salts of Li, Na, K, Ca, and Mg, etc. As the electrolyte, a lithium salt is preferably used. The lithium salt is not limited in particular, but may include Lil, LiCl, LiBr, LiF, LiBF₄, LiPF₆, LiAsF₆, LiSOsCFs, LiN (SO₂F)₂, LiN (SO₂CF₃)₂, LiN (SO₂CF₃CF₃)₂, LiBF₂ (C₂O₄), LiB (O₂C₂H₄)₂, LiB (O₂C₂H₄) F₂, LiB (OCOCF₃)₄, LiNOs, and Li₂SO₄, etc. In the above lithium salts, one type is used alone or two or more types are used in combination.

The concentration of the electrolyte in the electrolytic solution is not limited in particular, but is preferably 0.5 M or more, more preferably 0.7 M or more, still more preferably 0.9 M or more, or even more preferably 1.0 M or more. When the concentration of the electrolyte is within the above range, the SEI layer is more likely to be formed, and the internal resistance tends to be lower. The upper limit of the concentration of the electrolyte is not particularly limited, and the concentration of the electrolyte may be 10.0 M or less, 2 M or less, or 2.0 M or less.

### (2-3) BMS 400

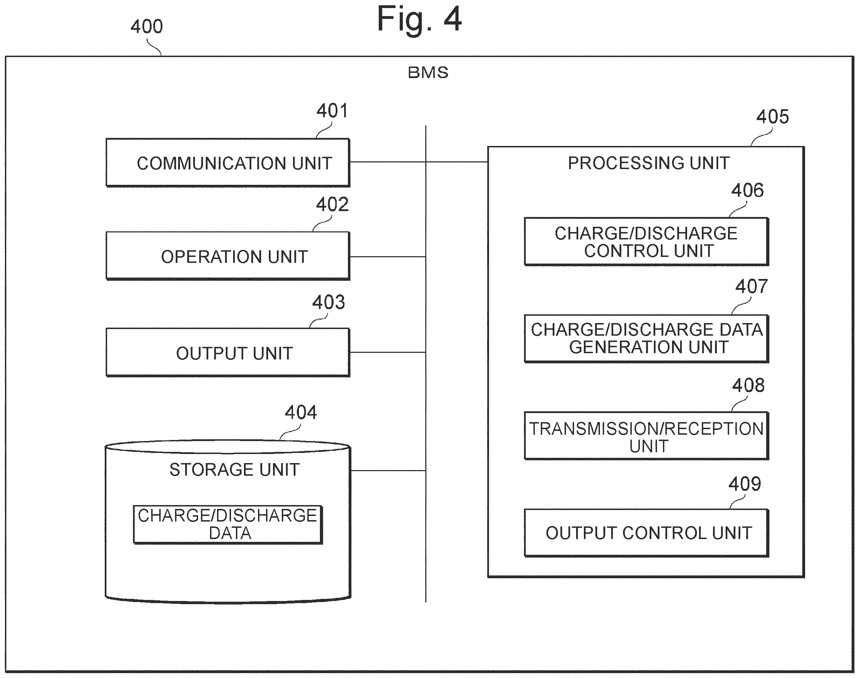

Fig. 4 is a block diagram showing an example of a functional configuration of the BMS 400 according to the present embodiment. The BMS 400 is comprised of, for example, one or a plurality of computers, and has a communication unit 401, an operation unit 402, an output unit 403, a storage unit 404, and a processing unit 405. The BMS 400 may be, for example, a device such as a PC, a smartphone, or a tablet terminal, and can manage the lithium secondary battery 101 and receive the provision of BaaS from the server device 20.

The communication unit 401 includes a communication interface circuit and connects the BMS 400 to the communication network N. The communication unit 401 transmits data supplied from the processing unit 405 to the server device 20 and the like via the communication network N. Further, the communication unit 401 supplies the data received from the server device 20 or the like via the communication network N to the processing unit 405.

The operation unit 402 may be any device as long as the BMS 400 can be operated, for example, a touch panel, a key button, or the like. The user can input characters, numbers, symbols, etc. using the operation unit 402. When the operation unit 402 is operated by the user, the operation unit 402 generates a signal corresponding to the operation. Then, the generated signal is supplied to the processing unit 405 as a user's instruction.

The output unit 403 includes, for example, a display unit and an audio output unit. The display unit may be any device as long as it can display a video, an image, or the like, and is, for example, a liquid crystal display, an organic EL (Electro-Luminescence) display, or the like. The display unit displays a video corresponding to video data supplied from the processing unit 405, an image corresponding to image data, and the like. Further, the audio output unit is configured as, for example, a speaker, and outputs audio based on audio data supplied from the processing unit 405.

The storage unit 404 includes, for example, a semiconductor memory device. The storage unit 404 stores an operating system program, a driver program, an application program, data, and the like used for processing in the processing unit 405. For example, the storage unit 404 stores, as driver programs, an input device driver program which controls the operation unit 402, an output device driver program which controls the output unit 403, and the like. Further, the storage unit 404 stores, as application programs, a program for managing the BMS 400, a program for using the BaaS provided by the server device 20, and the like. Various programs may be installed in the storage unit 404 from, for example, a computer-readable portable recording medium such as a CD-ROM or a DVD-ROM by using a known setup program or the like. Further, the storage unit 404 may store charge/discharge data which is data related to charging/discharging of the lithium secondary battery 101 managed by the BMS 400. A data structure of the charge/discharge data will be described later.

The processing unit 405 includes one or a plurality of processors and their peripheral circuits. The processing unit 405 generally controls the overall operation of the BMS 400, and is, for example, a CPU. The processing unit 405 controls the operations of the communication unit 401, the output unit 403, and the like so that various processes of the BMS 400 are executed in an appropriate procedure based on the program stored in the storage unit 404 and the operation of the operation unit 402, and the like. The processing unit 405 executes processing based on the program (operating system program, driver program, application program, etc.) stored in the storage unit 404. Further, the processing unit 406 can execute a plurality of programs (application programs and the like) in parallel.

The processing unit 405 includes, for example, a charge/discharge control unit 406, a charge/discharge data generation unit 407, a transmission/reception unit 408, and an output control unit 409. Each of these units is a functional module realized by a program executed by the processor included in the processing unit 405. Alternatively, each of these units may be mounted in the BMS 400 as an independent integrated circuit, a microprocessor, or firmware.

The charge/discharge control unit 406 controls charging and discharging of each lithium secondary battery 101 included in the battery module 100. The charge/discharge control unit 406 may control charging and discharging based on, for example, a setting stored in advance in the storage unit 404 or a setting input by an operation via the operation unit 402. The setting may be arbitrarily set depending on, for example, the time for charge/discharge, a residual capacity at the start of charge/discharge, a residual capacity at the end of charge/ discharge, a terminal voltage of the positive electrode and/or negative electrode at the start of charge/discharge, a terminal voltage of the positive electrode and/or negative electrode at the end of charge/discharge, etc.

The charge/discharge data generation unit 407 generates charge/discharge data which is data related to the charging/ discharging of the lithium secondary battery 101 managed by the BMS 400. The charge/discharge data generation unit 407 may store the generated charge/discharge data in the storage unit 404. The data structure of the charge/discharge data will be described later.

The transmission/reception unit 408 has functions as a transmission unit and a reception unit, and transmits various information and data to other information processing devices such as the server device 20 via the communication unit 401 and also receives various information and data from other information processing devices such as the server device 20 via the communication unit 401. The transmission/reception unit 408 transmits, for example, charge/discharge data to the server device 20. Further, the transmission/reception unit 408 receives, for example, various notification information from the server device 20.

The output control unit 409 causes the output unit 403 to output various information. For example, when the output unit 403 is configured as a display unit, the output control unit 409 generates video data or image data and causes the display unit to display a video based on the video data, an image based on the image data, or the like. Further, when the output unit 409 is configured as an audio output unit, the output control unit 409 generates audio data and causes the audio output unit to output audio.

### (3) Server Device 20

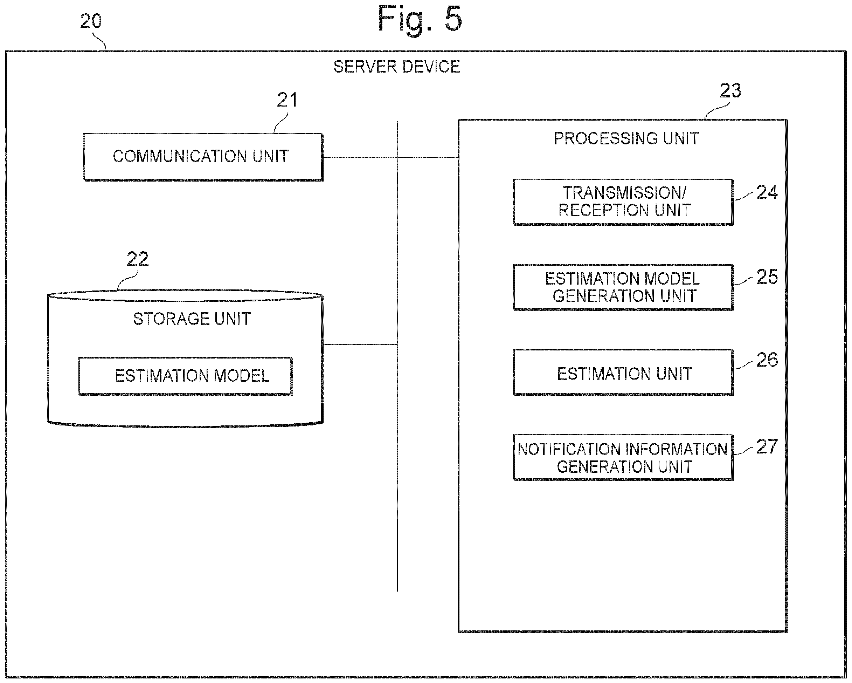

Fig. 5 is a block diagram showing an example of a functional configuration of the server device 20 according to the present embodiment. The server device 20 is, for example, an example of an information processing device comprised of one or a plurality of computers, and includes a communication unit 21, a storage unit 22, and a processing unit 23. The server device 20 provides BaaS for each BMS 400.

The communication unit 21 includes a communication interface circuit and connects the server device 20 to the communication network N. The communication unit 21 transmits the data supplied from the processing unit 23 to each BMS 400 or the like via the communication network N. Further, the communication unit 21 supplies the data received from each BMS 400 or the like via the communication network N to the processing unit 23.

The storage unit 22 includes, for example, a semiconductor memory device. The storage unit 22 stores an operating system program, a driver program, an application program, data, and the like used for processing in the processing unit 23. The various programs may be installed in the storage unit 22 from a computer-readable portable recording medium such as a CD-ROM or a DVD-ROM, for example using a known setup program or the like. The storage unit 22 may store, for example, an estimation model generated by an estimation model generation unit 25. Also, the storage unit 22 may store the charge/discharge data transmitted from the BMS 400. Further, the storage unit 22 may store information related to the specifications of the battery module 100 managed by each BMS 400 (information on the specifications of the lithium secondary battery 101 such as the negative electrode, the positive electrode, the negative electrode current collector, the positive electrode current collector, the separator, and the electrolytic solution, and information about the connection of each lithium secondary battery 101), and related to the specifications of the charger 200 and the load 300, and the like.

The processing unit 23 includes one or a plurality of processors and their peripheral circuits. The processing unit 23 generally controls the overall operation of the server device 20, and is, for example, a CPU. The processing unit 23 controls the operations of the communication unit 21 and the like so that various processes of the server device 20 are executed in an appropriate procedure based on the program and the like stored in the storage unit 22. The processing unit 23 executes processing based on the program (operating system program, driver program, application program, or the like) stored in the storage unit 22. Further, the processing unit 23 can execute a plurality of programs (application programs and the like) in parallel.

The processing unit 23 includes, for example, a transmission/reception unit 24, an estimation model generation unit 25, an estimation unit 26, and a notification information generation unit 27. Each of these units is a functional module realized by a program executed by the processor included in the processing unit 23. Alternatively, each of these units may be mounted in the server device 20 as an independent integrated circuit, a microprocessor, or firmware.

The transmission/reception unit 24 has functions as a transmission unit and a reception unit, and transmits various information and data to other information processing devices such as each BMS 400 via the communication unit 21 and receives various information and data from other information processing devices such as each BMS 400 via the communication unit 21. The transmission/reception unit 24 receives, for example, charge/discharge data from each BMS 400. Further, the transmission/reception unit 24 transmits, for example, various notification information to each BMS 400.

The estimation model generation unit 25 generates an estimation model for estimating a degradation indicator of the lithium secondary battery 101 based on the charge/discharge data received from each BMS 400. In particular, the estimation model generation unit 25 may integrate charge/discharge data received from a plurality of BMS 400s to generate a single estimation model. The estimation model generation unit 25 may generate an estimation model as a regression formula model by, for example, performing regression analysis based on the charge/discharge data. Alternatively, the estimation model generation unit 25 may generate an estimation model as a machine-learned model by, for example, performing machine learning based on the charge/discharge data.

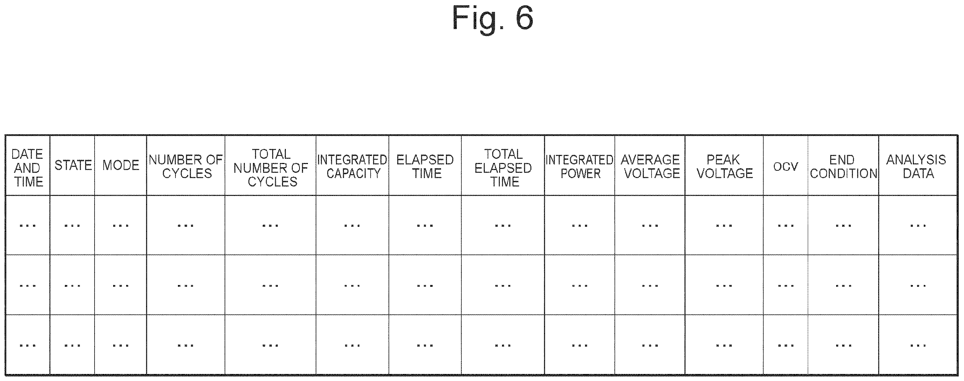

Here, description will be made about the data structure of the charge/discharge data with reference to Fig. 6. Fig. 6 is a diagram showing an example of the data structure of the charge/discharge data according to the present embodiment. Each record in a list shown in Fig. 6 corresponds to one cycle of charging or discharging of the lithium secondary battery 101 included in the BMS 400. Incidentally, the charge/discharge data further may include data on changes over time in each cycle, of at least any one of the voltage value measured by the voltage sensor 103, the current value measured by the current sensor 102, and the temperature value measured by the temperature sensor 104.

As shown in Fig. 6, the charge/discharge data includes, for example, the "date and time", a "state", a "mode", "the number of cycles", "the total number of cycles", an "integrated capacity", an "elapsed time", "integrated power", an "average voltage", a "peak voltage", an "OCV", an "end condition", and "analysis data" obtained by analyzing charge/discharge data. The "date and time" is information indicating the date and time when the cycle was executed. The "state" is information indicating whether the cycle is for charging or discharging, for example, 1 indicates charging and 2 indicates discharging. The "mode" is a mode setting related to repetition of charging and discharging. For example, "1" indicates a mode for executing a single charge/discharge cycle, and "2" indicates a mode for executing a plurality of charge/discharge cycles. The "number of cycles" is information indicating how many cycles the cycle is in the mode indicated by the "mode". The "total number of cycles" is information indicating the total number of charge/discharge cycles executed in the power supply device 10. The "integrated capacity" is information indicating the charge capacity recorded by charging in the record or the discharge capacity recorded by discharging in the record. The "elapsed time" is the time required for charging or discharging in the cycle. The "total elapsed time" is the total elapsed time from the start of charging or discharging of the power supply device 10 to the execution of charging or discharging of the cycle. The "integrated power" is information indicating the power charged by charging in the cycle or the power discharged by discharging in the cycle. The "average voltage" is the average voltage of the battery module 100 during charging or discharging in the cycle. The "peak voltage" is the peak voltage (maximum value of voltage) of the battery module 100 during charging or discharging in the cycle. The "OCV" is information indicating an OCV after discharge, which is an OCV after a predetermined time has elapsed since the end of discharging in the cycle, or an OCV after charging, which is an OCV after a predetermined time has elapsed since the end of charging in the cycle. Here, the OCV is also referred to as an open circuit voltage (Open Circuit Voltage), and may be an equilibrium voltage when an external power supply is connected between the electrodes of the battery and the current is set to 0 A and relaxed for a long time within a time range in which self-discharging is not made. Incidentally, the predetermined time may be, for example, the time required for the OCV to stabilize. The "end condition" is information indicating an end condition of charging/discharging of the cycle. The end condition may include, for example, that the voltage value of the lithium secondary battery 101 has reached a predetermined value, or may include that a predetermined time has elapsed since the start of charging/discharging. The "analysis data" is data obtained by analyzing the above-described charge/discharge data, and includes, for example, a "DC resistance", "dQ/dV", each peak position of "dQ/dV", each peak height of "dQ/dV", each peak width of "dQ/dV", and the like. The "DC resistance" is a numerical value obtained by dividing a difference between the voltage and the OCV at a certain point in time by the current. The "dQ/dV" is a numerical value obtained by dividing a current value by a voltage change per hour. The peak position, peak width, and peak height are information on the position, width, and height of the peak in a graph in which "dQ/dV" is plotted against the current, voltage, or other parameters.

When the estimation model is generated by regression analysis, the estimation model generation unit 25 may set explanatory variables in regression analysis based on the charge/discharge data and set objective variables based on the charge/discharge data, for example. In particular, in the regression analysis, the estimation model generation unit 25 may include a parameter based on the post-discharge OCV included in the charge/discharge data in an explanatory variable of the estimation model. The parameter may be, for example, "OCV after discharge" showing good linearity with a degradation indicator as described later, and in particular, only the "post-discharge OCV" may be an explanatory variable of the estimation model. In this case, the estimation model substantially becomes a graph or table showing the relationship between the "OCV after discharge" and the degradation indicator. Alternatively, the parameter may be, for example, "OCV after charge-OCV after discharge" showing good linearity with a degradation indicator as described later, and in particular, only "OCV after charge-OCV after discharge" may be an explanatory variable of the estimation model. In this case, the estimation model substantially becomes a graph or table showing the relationship between the "OCV after charge-OCV after discharge" and the degradation indicator. Further, in particular, in the regression analysis, the estimation model generation unit 25 may include the degradation indicator included in the charge/discharge data in the objective variable of the estimation model. The degradation indicator may be, for example, the "charge/discharge capacity" of the lithium secondary battery 101, or "SOH (State of Health)" which is a ratio obtained by dividing the "charge/discharge capacity" by the "initial charge/discharge capacity". Incidentally, the charge/discharge data generation unit 407 of the BMS 400 may arbitrarily configure the charge/discharge data as long as the estimation model generation unit 25 of the server device 20 includes the above-mentioned explanatory variables and objective variables handled in the regression analysis.

When the estimation model is generated by machine learning, the estimation model generation unit 25 may set the input in machine learning based on the charge/discharge data and set the output in machine learning based on the charge/discharge data, for example. In the machine learning, the estimation model generation unit 25 may include a parameter based on the post-discharge OCV included in the charge/discharge data in the input of the estimation model. The parameter may be, for example, "OCV after discharge" or "OCV after charge-OCV after discharge".

Incidentally, in addition to the above-described charge/discharge data, the estimation model generation unit 25 may generate an estimation model based on the information on the specifications of the battery module 100, the charger 200, and the load 300, etc. managed by each BMS 400. For example, when the estimation model is generated by regression analysis, the estimation model generation unit 25 may, for example, add at least part of the information about these specifications to the explanatory variables in the regression analysis. Further, when the estimation model is generated by machine learning, the estimation model generation unit 25 may include, for example, at least part of the information regarding these specifications in the input in machine learning.

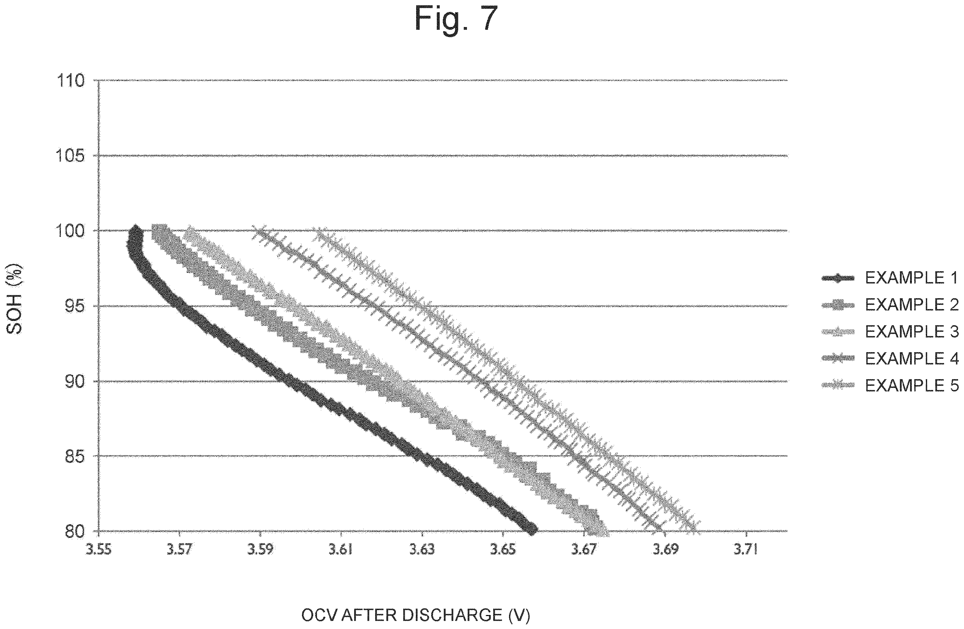

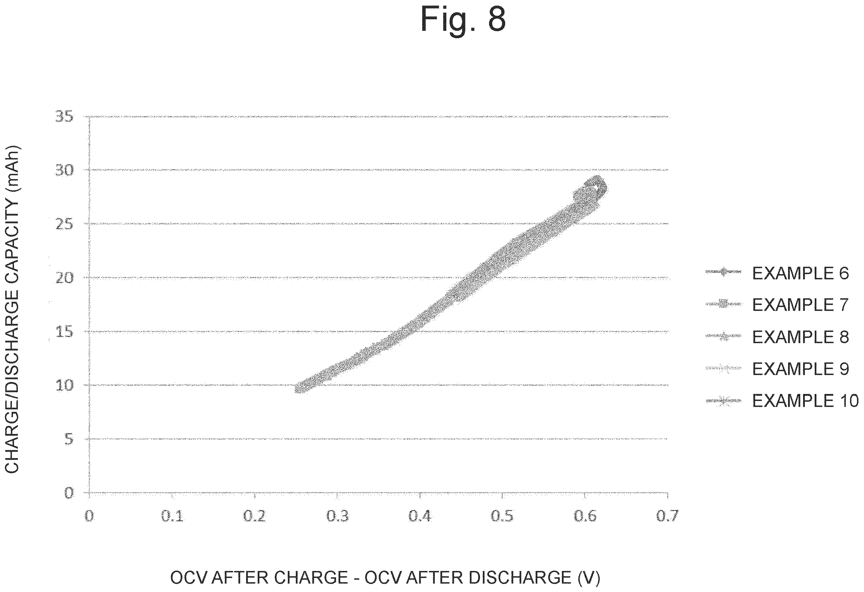

Here, description will be made about the linearity of the degradation indicator of the lithium secondary battery 101 with reference to Figs. 7 and 8. When the negative electrode 13 does not contain the negative electrode active material as in the lithium secondary battery 101 according to the present embodiment, the present inventors have found that the parameter based on the OCV after discharge indicates good linearity with the degradation indicator of the lithium secondary battery 101.

Fig. 7 is a diagram showing characteristic information of the "OCV after discharge" and "SOH" of the lithium secondary battery 101 according to various examples. Each example whose conditions are as shown in Table 1 below may be defined by battery conditions, operating conditions, and the like. The battery conditions may include the configurations of a positive electrode weight (mg/cm²) and a separator. Further, the operating conditions may include a charging rate (C) and a discharging rate (C). Incidentally, all upper limit voltages (voltages for stopping charging) were assumed to be 4.2 V, and all lower limit voltages (voltages for stopping discharging) were assumed to be 3 V. In Table 1, the separator "A" represents a polyethylene-based separator coated with PVDF.

**[Table 1]**

| | Battery Conditions | | Operating Conditions |
|---|---|---|---|
| | Positive Electrode Weight (mg/cm²) | Separator | Charging Rate (C)/Discharging Rate (C) |
| Example 1 | 10 | A | 0.1/0.3 |
| Example 2 | 10 | A | 0.2/0.3 |
| Example 3 | 15 | A | 0.1/0.3 |
| Example 4 | 20 | A | 0.1/0.3 |
| Example 5 | 25 | A | 0.1/0.3 |

As shown in Fig. 7, in the post-discharge OCV-SOH characteristic information according to Examples 1 to 5, in any case, linearity can be seen between the "OCV after discharge" and "SOH" depending on the conditions of each example. Therefore, it can be said that the accuracy of the estimated value (e.g., SOH) of the degradation indicator by the estimation model is improved by including the "OCV after discharge" as the explanatory variable of the estimation model when the estimation model is generated by regression analysis, or as the input of machine learning when the estimation model is generated by machine learning.

Fig. 8 is a diagram showing characteristic information of the "OCV after charge-OCV after discharge" and the "charge/discharge capacity" of the lithium secondary battery 101 according to various examples. The conditions of each example are as shown in Table 2 below. Each example may be defined by battery conditions, operating conditions, and the like. The battery conditions may include the configurations of a positive electrode weight (mg/cm²) and a separator. Further, the operating conditions may include a charging rate (C) and a discharging rate (C). Incidentally, all upper limit voltages (voltages for stopping charging) were assumed to be 4.2 V, and all lower limit voltages (voltages for stopping discharging) were assumed to be 3 V. In Table 2, the separator "B" represents a polyethylene-based separator coated with aramid, and the separator "C" represents a polyethylene-based separator coated with PVDF with a thickness different from that of the separator "A".

**[Table 2]**

| | Battery Conditions | | Operating Conditions |
|---|---|---|---|
| | Positive Electrode Weight (mg/cm²) | Separator | Charging Rate (C)/Discharging Rate (C) |
| Example 6 | 10 | B | 0.1/0.3 |
| Example 7 | 10 | B | 0.2/0.3 |
| Example 8 | 10 | C | 0.1/0.3 |
| Example 9 | 10 | D | 0.1/0.3 |
| Example 10 | 10 | E | 0.1/0.3 |

As shown in Fig. 8, in the "OCV after charge-OCV after discharge" and "charge/discharge capacity" according to Examples 6 to 10, in any case, linearity can be seen between the "OCV after charge-OCV after discharge" and "charge/discharge capacity". Therefore, it can be said that the accuracy of the estimated value (e.g., SOH) of the degradation indicator by the estimation model is improved by including the "OCV after charge-OCV after discharge" as the explanatory variable of the estimation model when the estimation model is generated by regression analysis, or as the input of machine learning when the estimation model is generated by machine learning.

The estimation unit 26 acquires an estimated value of the degradation indicator of the lithium secondary battery 101 using the estimation model. The estimation unit 26 acquires, for example, charge/discharge data from any BMS 400 constituting the management system 1 and inputs the charge/discharge data to the estimation model to thereby acquire an estimated value of the degradation indicator of the lithium secondary battery 101 managed by the BMS 400. The estimation unit 26 may output the estimated value of the lithium secondary battery 101 managed by the BMS 400 when a predetermined estimation condition is satisfied.

The notification information generation unit 27 generates predetermined notification information based on the estimated value. Here, the content of the notification information is not particularly limited as long as it is based on the estimated value of the degradation indicator, but it may include, for example, information indicating the estimated value, information indicating comparison of the estimated value with a predetermined threshold, information indicating when to replace the lithium secondary battery 101, a message prompting the replacement of the lithium secondary battery 101, advice on the operation of the lithium secondary battery 101, and the like. Further, the notification information generation unit 27 may determine a predetermined notification condition based on the estimated value, or may generate the notification information when it is determined that the predetermined notification condition is satisfied.

### (4) Operation Process

### (4-1) Generation Process of Estimation Model

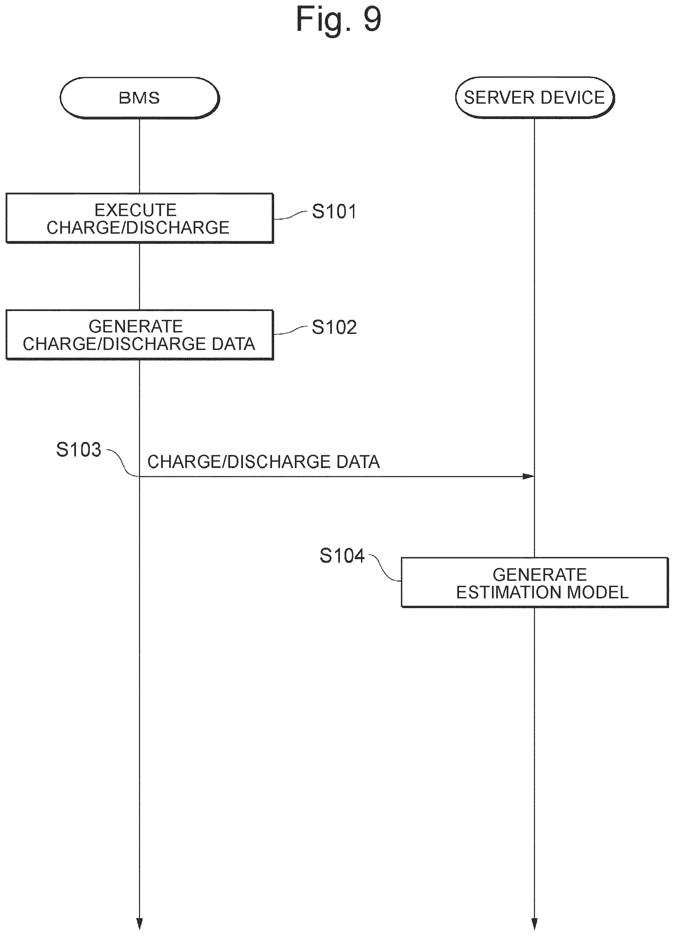

Fig. 9 is a diagram showing an example of an operation sequence of the generation process of the estimation model by the management system 1 according to the present embodiment.

(S101) First, the charge/discharge control unit 406 of the BMS 400 executes charging/discharging of the battery module 100. The charge/discharge control unit 406 controls the charger 200 and the load 300 based on the settings related to the charging/discharging stored in the storage unit 404, for example, to control the charging and discharging of the battery module 100. The settings related to the charging/discharging may include, for example, the time for charging/discharging, the remaining capacity at the start of charging/discharging, the remaining capacity at the end of charging/discharging, the terminal voltage of the positive electrode and/or the negative electrode at the start of charging/discharging, the terminal voltage of the positive electrode and/or negative electrode at the end of charging/discharging, and the like. In charge/discharge control, the charge/discharge control unit 406 may monitor at least any of the current value supplied from the current sensor 102, the voltage value supplied from the voltage sensor 103, and the temperature value supplied from the temperature sensor 104.

(S102) Next, the charge/discharge data generation unit 407 of the BMS 400 generates charge/discharge data based on the charge/discharge control in Step S101. The charge/discharge data may have, for example, the data structure shown in Fig. 6.

(S103) Next, the transmission/reception unit 408 of the BMS 400 transmits the charge/discharge data generated in Step S102 to the server device 20. The transmission/reception unit 24 of the server device 20 receives the charge/discharge data from the BMS 400 and stores it in the storage unit 22. The timing at which the transmission/reception unit 408 transmits the charge/discharge data and the unit of the charge/discharge data to be transmitted may be arbitrarily set. The timing of transmitting the charge/discharge data is not limited in particular, but may be, for example, when the number of cycles exceeds a predetermined threshold, a periodic or aperiodic specific date and time, when the charge/discharge capacity falls below a predetermined threshold, when the user performs a predetermined operation via the operation unit 402, when a request from the server device 20 is received by the BMS 400, etc.

(S104) Next, the estimation model generation unit 25 of the server device 20 generates an estimation model based on the charge/discharge data supplied from each BMS 400 at a predetermined timing. The estimation model generation unit 25 may generate an estimation model as a regression formula model by, for example, performing a regression analysis based on the charge/discharge data supplied from each BMS 400. Alternatively, the estimation model generation unit 25 may generate an estimation model as a machine-learned model by, for example, performing machine learning based on the charge/discharge data supplied from each BMS 400. The timing to generate the estimation model is not limited in particular, but may be a periodic or aperiodic specific date and time, or the like.

### (4-2) Estimation Process of Degradation Indicator

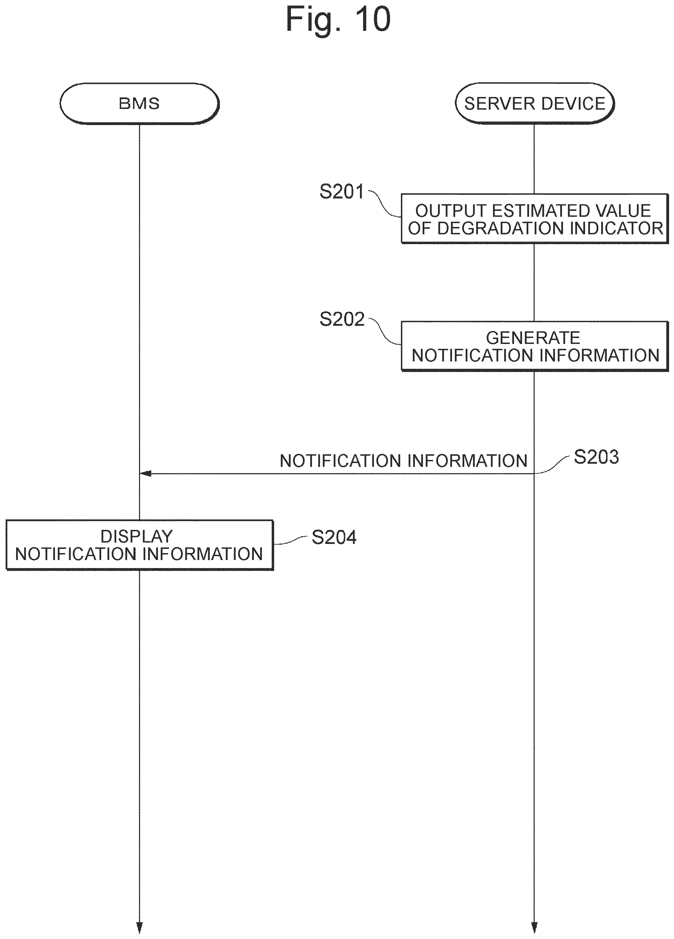

Fig. 10 is a diagram showing an example of an operation sequence of an estimation process of the degradation indicator by the management system 1 according to the present embodiment.

(S201) First, when the predetermined conditions for estimation of the degradation indicator for the predetermined BMS 400 are met, the estimation unit 26 of the server device 20 outputs the estimated value of the degradation indicator of the lithium secondary battery 101 managed by the predetermined BMS 400 using the estimation model. Here, the predetermined conditions for estimating the degradation indicator are not particularly limited, but may include, for example, the reception of charge/discharge data from the predetermined BMS 400, the arrival of a periodic or aperiodic specific date and time, the reception of a request from the predetermined BMS 400 by the server device 20, and the like.

(S202) Next, the notification information generation unit 27 of the server device 20 generates notification information based on the estimated value of the degradation indicator generated in Step S201. Here, the content of the notification information is not limited in particular as long as it is based on the estimated value of the degradation indicator, but may include, for example, information indicating the estimated value, information indicating comparison of the estimated value with a predetermined threshold, information indicating the time when to replace the lithium secondary battery 101, a message prompting the replacement of the lithium secondary battery 101, advice on the operation of the lithium secondary battery 101, and the like.

(S203) Next, the transmission/reception unit 24 of the server device 20 transmits the generated notification information to the predetermined BMS 400 described above. The transmission/reception unit 408 of the predetermined BMS 400 receives the notification information from the server device 20.

(S204) Next, the output control unit 409 of the BMS 400 causes the output unit 403 to output various information. For example, when the output unit 403 is configured as a display unit, the output control unit 409 generates video data or image data based on the notification information and causes the display unit to display a video based on the video data, an image based on the image data, or the like. Further, when the output unit 403 is configured as an audio output unit, the output control unit 409 generates audio data based on the notification information and causes the audio output unit to output audio. Thus, as the content of the notification information, information indicating the estimated value, information indicating the comparison of the estimated value with a predetermined threshold, information indicating the time when to replace the lithium secondary battery 101, a message prompting the replacement of the lithium secondary battery 101, etc. are output from the output unit 403.

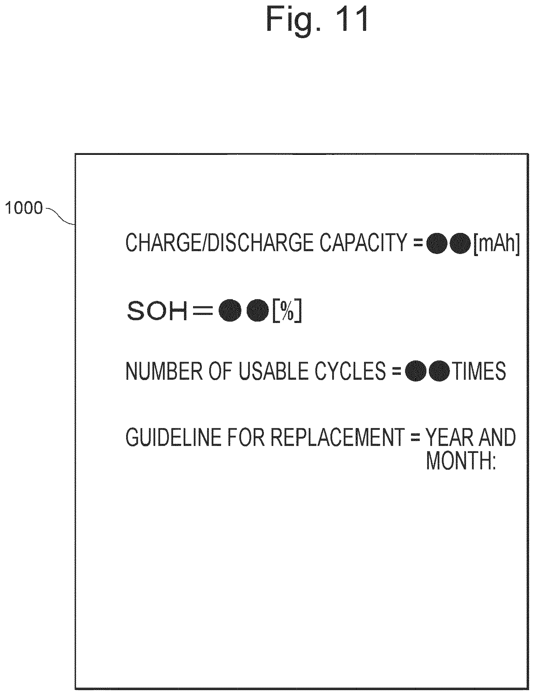

Fig. 11 is a diagram showing an example of a screen 1000 of notification information displayed on the display unit when the output unit 403 is configured as the display unit. As shown in Fig. 11, the screen 1000 may include an estimated value of a degradation indicator such as the charge/discharge capacity or SOH. Further, as shown in Fig. 11, the screen 1000 may include information such as the number of usable cycles and a guideline for replacement as information based on the estimated value of the degradation indicator.

The embodiments described above are for facilitating the understanding of the present invention, and are not intended to limit the interpretation of the present invention. Each element included in the embodiment and its arrangement, material, condition, shape, size, and the like are not limited to those exemplified, and can be appropriately changed. Further, the configurations shown in the different examples can be partially replaced or combined.

## Claims

1. An information processing device comprising:
a first reception unit which receives from a plurality of secondary battery management systems, charge/discharge data of secondary batteries managed by the secondary battery management systems; and
an estimation model generation unit which generates an estimation model for estimating a degradation indicator indicating a state of degradation of the secondary battery based on the charge/discharge data.

2. The information processing device according to claim 1, wherein the secondary battery does not contain an active material in a negative electrode.

3. The information processing device according to claim 1 or 2, wherein the estimation model generation unit generates the estimation model as a regression formula model by executing a regression analysis based on the charge/discharge data.

4. The information processing device according to claim 3, wherein the estimation model generation unit includes a parameter based on a post-discharge open circuit voltage (OCV) included in the charge/discharge data in an explanatory variable of the estimation model in the regression analysis.

5. The information processing device according to claim 4, wherein the parameter is an OCV after discharge.

6. The information processing device according to claim 5, wherein the estimation model generation unit sets only the OCV after discharge as an explanatory variable of the estimation model in the regression analysis.

7. The information processing device according to claim 4, wherein the parameter is OCV after charge-OCV after discharge.

8. The information processing device according to claim 7, wherein the estimation model generation unit sets only the OCV after charge-OCV after discharge as an explanatory variable of the estimation model in the regression analysis.

9. The information processing device according to claim 1 or 2, wherein the estimation model generation unit generates the estimation model as a machine-learned model by executing machine learning based on the charge/discharge data.

10. The information processing device according to claim 9, wherein the estimation model generation unit includes a parameter based on a post-discharge open circuit voltage (OCV) included in the charge/discharge data in the input of the estimation model in the machine learning.

11. The information processing device according to claim 10, wherein the parameter is an OCV after discharge.

12. The information processing device according to claim 10, wherein the parameter is OCV after charge-OCV after discharge.

13. The information processing device according to any one of claims 1 to 12, further including:
a second reception unit which receives from one of the secondary battery management systems, charge/discharge data of a secondary battery managed by the one secondary battery management system;
an estimation unit which inputs the charge/discharge data acquired from the one secondary battery management system to the estimation model to acquire an estimated value of a degradation indicator of the secondary battery managed by the one secondary battery management system;
a notification information generation unit which generates notification information based on the acquired estimated value; and
a transmission unit which transmits the notification information to the one secondary battery management system.

14. The information processing device according to claim 13, wherein the notification information includes at least either of information indicating the estimated value and a message related to the secondary battery based on the estimated value.

15. The information processing device according to claim 13 or 14, wherein the notification information generation unit determines a predetermined notification condition based on the estimated value, and generates the notification information when the notification condition is determined to be satisfied.

16. The information processing device according to any one of claims 1 to 15, wherein each of the secondary battery management systems manages a second battery whose negative electrode does not contain a negative electrode active material.

17. An information processing method comprising the steps of causing a computer to execute:
receiving from a plurality of secondary battery management systems, charge/discharge data of secondary batteries managed by the secondary battery management systems; and
generating an estimation model for estimating a degradation indicator indicating a state of degradation of the secondary battery based on the charge/discharge data.

18. A program for allowing a computer to function as:
a first reception unit which receives from a plurality of secondary battery management systems, charge/discharge data of secondary batteries managed by the secondary battery management systems; and
an estimation model generation unit which generates an estimation model for estimating a degradation indicator indicating a state of degradation of the secondary battery based on the charge/discharge data.
